# FASCICULE DE BREVET EUROPEEN

(11) **EP 2 348 286 B1**
(45) Date de publication et mention de la délivrance du brevet: **22.08.2012**
(21) Numéro de dépôt: 11150418.9
(22) Date de dépôt: 07.01.2011
(51) Int. Cl.: G01D 5/244

(54) **Mesure d'un mouvement cyclique d'une pièce ferromagnétique**
Messung der zyklischen Bewegung eines ferromagnetischen Teils
Measurement of a cyclic movement of a ferromagnetic part

(30) Priorité: 21.01.2010 FR 1050399
(43) Date de publication de la demande: 27.07.2011
(73) Titulaire: COMMISSARIAT A L'ENERGIE ATOMIQUE ET AUX ENERGIES ALTERNATIVES, 75015 Paris (FR)
(72) Inventeur: Le Goff, Alexis, 78000, VERSAILLES (FR); Blanpain, Roland, 38380, ENTRE-DEUX-GUIERS (FR)
(74) Mandataire: de Beaumont, Michel

(56) Documents cités:
- EP-A2- 0 828 161
- EP-A2- 1 146 319
- EP-A2- 1 541 971

## Description

### Domaine de l'invention

La présente invention concerne de façon générale les systèmes de mesure exploitant le champ magnétique généré par une pièce ferromagnétique pour estimer des grandeurs (vitesse, position, etc.) liées à un mouvement cyclique de cette pièce. L'invention concerne plus particulièrement les mesures liées à un mouvement rotatif d'une pièce ferromagnétique.

### Exposé de l'art antérieur

Il est connu d'exploiter des mesures de champ magnétique pour déterminer la vitesse de rotation d'une roue de véhicule automobile. Par exemple, le document EP-A-0828161 décrit un procédé et dispositif de détection dans lequel un capteur magnétique est placé à proximité de la roue pour exploiter une signature ferromagnétique de celle-ci et en déduire la vitesse de rotation. Pour réduire l'influence d'autres sources magnétiques à proximité de la roue (le châssis, la portière, etc.), il est prévu d'effectuer une mesure différentielle de signaux issus de plusieurs capteurs placés à proximité de la roue. On élimine ainsi les composantes du champ provenant des sources magnétiques de valeur fixe placées à proximité.

Il serait souhaitable de pouvoir extraire des informations sur la rotation d'une pièce ferromagnétique (par exemple, le vilebrequin, l'arbre à cames, etc.) d'un moteur d'un véhicule automobile par mesure de champ magnétique.

Aujourd'hui, la position angulaire du vilebrequin ou de l'arbre à cames est déterminée par un codeur optique. Un tel codeur doit alors être isolé des salissures qui fausseraient les mesures. Cela engendre une réalisation complexe.

Mais, la transposition des systèmes magnétiques connus pour les roues à l'évaluation du mouvement d'autres éléments du véhicule et notamment à l'analyse du mouvement d'éléments rotatifs du moteur pose problème dans la mesure où des champs magnétiques variables, d'amplitude non négligeable par rapport au champ magnétique des pièces dont on souhaite mesurer la rotation, viennent perturber la mesure.

Le document EP-A-1146319 décrit un transducteur de position utilisant un capteur magnétique et comportant deux entités à des positions différentes dans un axe perpendiculaire au plan de l'objet dont on souhaite détecter le déplacement. Des pièces magnétiques définissent une échelle de mesure. Ce document mesure des déplacements dans le plan.

Le document EP-1541971 décrit un codeur équipé de moyens détection de mouvement pour détecter le mouvement d'un corps en déplacement et un circuit de traitement du signal associé à des moyens de détection d'un bruit superposé au signal de détection de mouvement.

### Résumé

Un objet de la présente invention est de proposer un procédé et un système d'extraction d'informations relatives à la rotation d'une pièce ferromagnétique à partir d'une mesure du champ magnétique émis par cette pièce, dans un environnement bruité par d'autres sources variables.

Plus généralement, un objet d'un mode de réalisation de la présente invention vise l'analyse d'un mouvement cyclique d'une pièce ferromagnétique dans un environnement bruité par une ou plusieurs sources variables.

Pour atteindre tout ou partie de ces objets ainsi que d'autres, il est prévu un système de mesure d'un mouvement cyclique d'une pièce ferromagnétique dans un environnement bruité au moins par une source électrique à composante alternative, comportant :
au moins un premier magnétomètre sensible à la pièce en mouvement ;
un capteur d'une image du courant dans ladite source électrique ;
des moyens pour calculer une estimation du bruit lié à la source électrique sur un signal mesuré par le premier magnétomètre ; et
des moyens pour soustraire ladite estimation au signal mesuré.

Selon un mode de réalisation de la présente invention, ladite image du courant dans ladite source alternative est la tension aux bornes de celle-ci.

Selon un mode de réalisation de la présente invention, lesdits moyens de calcul comportent au moins un filtre de Wiener.

Selon un mode de réalisation de la présente invention, ledit magnétomètre est placé plus près de ladite pièce que de toute autre pièce ferromagnétique en mouvement.

Selon un mode de réalisation de la présente invention, le système comporte :
au moins un deuxième magnétomètre placé à proximité d'une deuxième pièce ferromagnétique en mouvement ;
des moyens pour calculer une estimation du bruit lié à cette deuxième pièce sur le signal mesuré par le premier magnétomètre ; et
des moyens pour soustraire cette estimation au signal mesuré.

Selon un mode de réalisation de la présente invention, ladite source à composante alternative est un alternateur associé à un moteur de véhicule.

Selon un mode de réalisation de la présente invention, ladite source à composante alternative est le courant alternatif d'un moteur électrique.

On prévoit également un procédé d'évaluation d'un mouvement cyclique d'au moins une pièce ferromagnétique dans un environnement bruité au moins par une source électrique à composante alternative, comportant les étapes de :
mesurer une image du champ magnétique influencé au moins par ladite pièce ;
mesurer une image du courant dans ladite source électrique ;
appliquer un corrélofiltrage à ladite image du champ magnétique pour éliminer l'influence de ladite source électrique.

Selon un mode de réalisation de la présente invention, une composante de bruit provenant d'une autre pièce ferromagnétique est éliminée par corrélofiltrage en utilisant au moins un deuxième magnétomètre associé à cette deuxième pièce.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue schématique d'un véhicule automobile équipé d'un système de mesure du mouvement d'un élément en rotation d'un moteur selon un mode de réalisation de la présente invention ;
la figure 2 est une vue schématique en perspective et partielle d'éléments mobiles d'un exemple de moteur automobile ;
la figure 3 est un schéma-bloc illustrant un mode de mise en oeuvre de la présente invention ;
la figure 4 illustre sous forme de chronogrammes un exemple de réponse obtenue avec le système de la figure 3 ; et
la figure 5 est un schéma-bloc d'un autre mode de réalisation de la présente invention.

### Description détaillée

De mêmes éléments ont été désignés par de mêmes références aux différentes figures. Par souci de clarté, seul les éléments et étapes utiles à la compréhension de l'invention ont été représentés et seront décrits. En particulier, la réalisation pratique d'un magnétomètre capable de fournir une information selon un ou plusieurs axes n'a pas été détaillée, l'invention étant compatible avec les magnétomètres usuels. De plus, l'exploitation faite des informations relatives au mouvement cyclique analysé n'a pas non plus été détaillée, l'invention étant là encore compatible avec l'exploitation usuelle des mesures de vitesse, de position, etc. d'une pièce en mouvement cyclique.

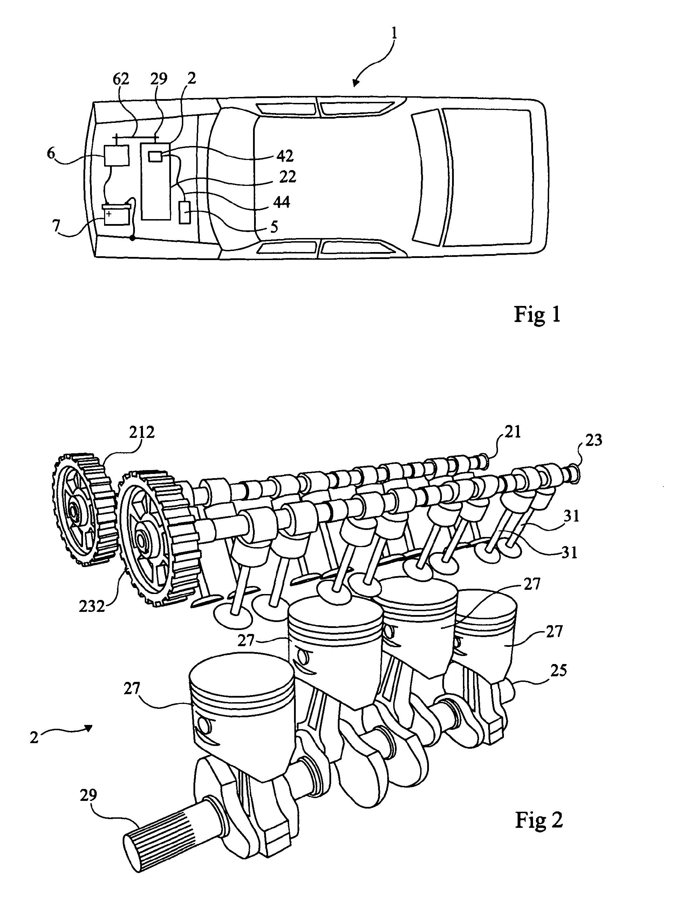

La figure 1 est une vue de dessus schématique d'un véhicule automobile 1 équipé d'un système d'analyse de mouvement rotatif d'une pièce ferromagnétique du moteur selon un mode de réalisation de la présente invention.

Dans cet exemple, on souhaite évaluer la vitesse de rotation d'un arbre à cames (non représenté en figure 1) du moteur 2 du véhicule.

La figure 2 est une vue en perspective partielle représentant des éléments à mouvement cyclique contenus dans un moteur 2 de véhicule automobile. Dans l'exemple de la figure 2, il s'agit d'un moteur à double arbre à cames en tête 21 et 23. Un vilebrequin 25 du moteur, des pistons 27, un arbre moteur 29 à l'extrémité du vilebrequin, des soupapes d'admission et d'échappement 31 associées à chaque cylindre sont également représentés en figure 2. Ces éléments font partie des éléments du moteur dont on peut analyser les mouvements cycliques selon d'autres modes de réalisation. L'arbre moteur 29 entraîne une courroie de distribution non représentée qui engrène entre autres avec des roues dentées 212 et 232 associées aux arbres à cames 21 et 23. Une autre courroie (62, figure 1) entrainée par l'arbre moteur 29 sert à entrainer un alternateur 6 destiné à recharger une batterie 7.

Dans le mode de réalisation de la figure 1, un capteur magnétique 42 est placé sur la carcasse 22 du moteur 2, à proximité de l'arbre à cames, et les signaux qu'il récupère sont envoyés par une liaison filaire 44 à un circuit 5 d'interprétation et d'analyse.

L'inventeur s'est aperçu que la source principale de perturbation des mesures par un magnétomètre placé à proximité d'un élément ferromagnétique en mouvement cyclique du moteur provient de l'alternateur, et plus précisément, du fait qu'il s'agit d'une source électrique à composante alternative.

Par ailleurs, cette composante alternative peut être déterminée à partir d'une mesure de la tension aux bornes de l'alternateur, sans qu'il soit nécessaire de recourir à un capteur magnétique supplémentaire pour une mesure différentielle.

Selon un mode de réalisation de la présente invention, il est donc prévu de capter l'image du courant de l'alternateur à partir d'une mesure de la tension à ses bornes et d'éliminer le bruit engendré par l'alternateur sur les signaux produits par le magnétomètre 42.

Typiquement, en plaçant un magnétomètre contre la carcasse du moteur le plus près possible de l'arbre à cames, on capte un champ ayant une amplitude de l'ordre d'un microtesla. La perturbation liée à l'alternateur sur ce magnétomètre est du même ordre de grandeur et ne peut donc être négligée.

L'élimination du bruit lié à l'alternateur peut suffire à obtenir des signaux exploitables. En particulier, si le magnétomètre est placé suffisamment près de l'arbre à cames (dans l'exemple de la figure 2, en haut du moteur), le bruit provenant d'autres sources en rotation peut être négligé et ne perturbe pas les mesures.

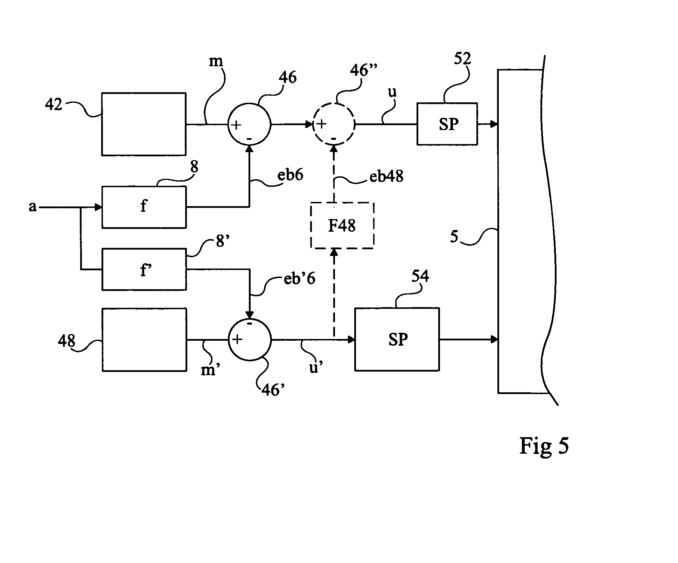

Dans le cas contraire, au moins un deuxième magnétomètre est utilisé pour évaluer le bruit d'une ou plusieurs sources de bruit non négligeables. Par exemple, si ce bruit vient du vilebrequin, un magnétomètre est placé contre la carcasse, le plus près possible du vilebrequin (dans l'exemple de la figure 2, en bas du moteur). Les signaux provenant de ce deuxième magnétomètre sont exploités pour extraire un bruit issu du vilebrequin, comme on le verra par la suite en relation avec la figure 5.

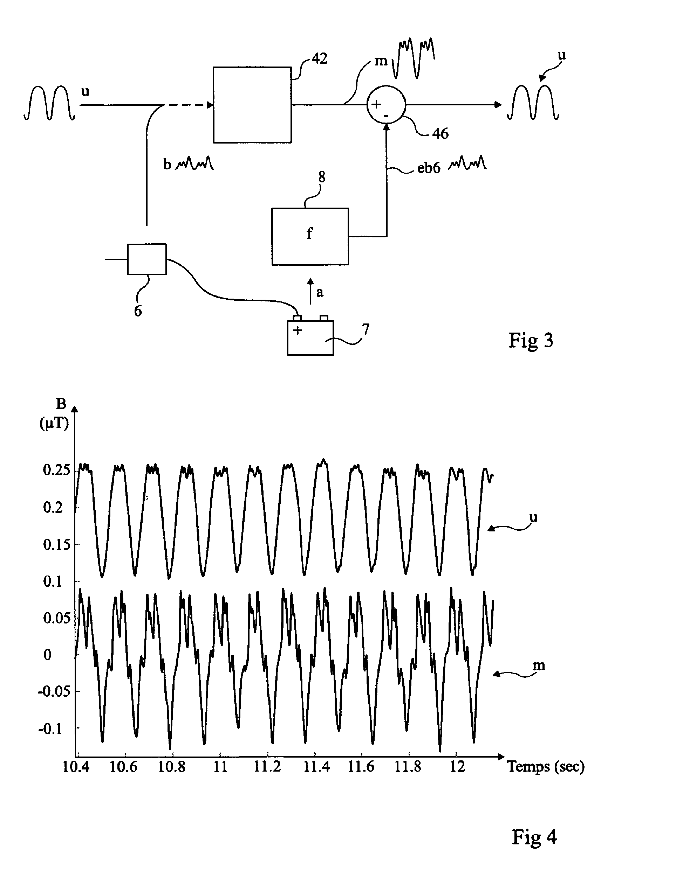

La figure 3 est un schéma bloc illustrant un mode de mise en oeuvre de la présente invention selon lequel un signal m issu du magnétomètre 42 est soumis à un filtrage par une technique dite de corrélofiltrage pour éliminer la perturbation liée à l'alternateur 6. On considère que le signal mesuré est perturbé par le champ magnétique provenant des courants électriques allant de l'alternateur à la batterie. Bien que la batterie stocke une tension continue, le courant provenant de l'alternateur (ou la tension aux bornes de la batterie) présente un composante alternative.

Comme l'illustre la figure 3, on peut considérer que le signal mesuré par le magnétomètre 42 correspond à l'addition d'un signal utile u représentant le champ magnétique de l'arbre à cames et d'un signal de bruit b provenant de l'alternateur.

Or, en plus de l'observation du signal bruité m, on a accès à une information liée au bruit b, indépendamment du signal utile u (non corrélé avec le signal utile). Ce signal correspond à la tension a aux bornes de la batterie 7 qui peut être mesurée et qui n'est pas influencée par le champ magnétique de l'arbre à cames. Il est alors possible de déterminer un filtre 8 (par exemple un filtre dit de Wiener) dont la fonction de transfert f permet d'obtenir, à partir de la tension de batterie a, une estimation eb6 du bruit b. Cette estimation eb6 est alors soustraite (soustracteur 46) du signal mesuré m pour restituer le signal utile u ne représentant plus que le champ magnétique produit par l'arbre à cames.

La fonction de transfert f peut s'écrire f(**ν**)=Sₘₐ(**ν**)/Sₐₐ(**ν**), où Sₘₐ(**ν**) représente la densité inter-spectrale de puissance entre l'observation de la tension batterie a et la mesure bruitée m, et où Sₐₐ(**ν**) représente la densité spectrale de puissance moyenne du signal a.

Les techniques de corrélofiltrage pour éliminer la contribution d'un bruit dont on possède une référence dite de "bruit seul" sont connues. On pourra se référer par exemple à l'article "Application du corrélofiltre à l'élimination de raies en présence de bruit stationnaire" de D. BAUDOIS, A. SILVENT (septième colloque sur le traitement du signal et ses applications, Nice 28 mai au 2 juin 1979).

La figure 4 illustre le fonctionnement du système d'extraction du signal utile représenté en figure 3. Ont été représentés en partie supérieure un exemple de signal utile u représentant le champ magnétique produit par l'arbre à cames et en partie basse le signal bruité m mesuré par le magnétomètre 42. Dans l'exemple de la figure 3, on suppose un décalage du niveau de référence du signal utile (qui oscille entre environ 0,1 µT et environ 0,25 µT) par rapport au signal mesuré (qui oscille entre environ -0,1 µT et environ 0,1 µT).

L'interprétation du signal utile u pour en déduire des informations de vitesse, de position angulaire, d'accélération, etc. ne requiert que du traitement de signal à partir de références temporelle et de position. Les références de position pourront, par exemple, être obtenues par un étalonnage lors de la fabrication. En variante, on pourra mettre en oeuvre une procédure d'apprentissage.

Si l'alternateur 6 ne tourne pas en permanence (cas par exemple d'un véhicule électrique), la prise en compte de la perturbation liée à l'alternateur est désactivée pendant les périodes où il ne fonctionne pas.

La figure 5 est un schéma bloc d'un autre mode de réalisation illustrant le fait que plusieurs capteurs magnétiques 42 et 48 peuvent être placés à proximité de différentes pièces métalliques en mouvement cyclique. Par exemple, en plus du capteur 42 placé à proximité de l'arbre à cames, un autre capteur 48 est placé à proximité du vilebrequin (25, figure 2) pour en mesurer la position angulaire ou la vitesse. Comme pour l'arbre à cames, la perturbation majoritaire du signal mesuré m' provient de l'alternateur 6. Il faut donc effectuer une opération de filtrage du signal mesuré m' pour éliminer la composante eb'6 estimée du bruit à partir de la mesure de la tension batterie a. La fonction de transfert f' du filtre 8' est différente de celle du filtre 8 de l'arbre à cames dans la mesure où les capteurs 42 et 48 ne sont pas à la même distance de l'alternateur 6 (et ne sont de plus probablement pas dans la même orientation). Les signaux utiles u et u' fournis par des soustracteurs 46 et 46' sont ensuite exploités par des circuits 52 et 54 de traitement du signal (SP) pour que les informations relatives au mouvement de l'arbre à cames et du vilebrequin soient transmises au circuit électronique 5, par exemple l'ordinateur de bord du véhicule.

Dans le cas où le signal u de l'arbre à cames récupéré après filtrage des perturbations liées à l'alternateur reste trop bruité par une autre source ferromagnétique, il est possible d'appliquer la même technique de corrélofiltrage pour en éliminer la contribution. Cette fonctionnalité est illustrée en pointillé en figure 5 où l'on considère que le vilebrequin introduit une perturbation non négligeable sur le signal mesuré par le magnétomètre 42 associé à l'arbre à cames. Dans ce cas, on considère que le signal u' fourni par le soustracteur 46' représente une composante de bruit seul du vilebrequin et qu'il est alors possible d'estimer (signal eb48) sa contribution sur le signal issu du magnétomètre 42 par un filtre f48 de Wiener calculé de façon similaire à celle exposée ci-dessus et de la soustraire (soustracteur 46") au signal mesuré m.

D'autres capteurs peuvent encore être associés à d'autres éléments.

Un avantage de la présente invention est qu'en disposant un magnétomètre à proximité d'une pièce ferromagnétique en mouvement cyclique, on peut obtenir des informations de façon simple malgré le bruit non négligeable lié à une source à composante alternative.

Il est désormais possible d'analyser le mouvement de pièces du moteur par mesure de champ magnétique, insensible aux salissures forcément présentes dans l'environnement du moteur.

Un autre avantage est que l'élimination du bruit de l'alternateur ne requiert qu'un traitement de signal à partir d'une mesure de la tension de la batterie. En particulier, aucun magnétomètre n'est requis pour éliminer le bruit de l'alternateur.

Bien que l'invention ait été décrite ci-dessus en relation avec une application à un moteur de véhicule automobile, elle s'applique plus généralement dès qu'un mouvement cyclique est opéré par une pièce ferromagnétique et que celle-ci se trouve à proximité d'une source électrique à composante alternative. Par exemple, dans le cas d'un moteur d'une machine outil, il est possible d'extraire d'un champ magnétique capté par un magnétomètre des informations relatives à la position ou à la vitesse de l'arbre du moteur alors même que celui-ci est perturbé par le courant alternatif d'alimentation du moteur.

Divers modes de réalisation ont été décrits. Diverses variantes et modifications apparaîtront à l'homme de l'art. En particulier, le choix des positions respectives du ou des magnétomètres à proximité des éléments ferromagnétiques dépend de la configuration de la pièce dont on souhaite extraire des informations et de son environnement. De préférence, le ou les magnétomètres destinés à mesurer le champ d'une pièce donnée sont placés plus près de cette pièce que de toute autre pièce ferromagnétique en mouvement.

De plus, bien que l'invention ait été décrite en relation avec un exemple utilisant un seul magnétomètre par pièce ferromagnétique, on pourra utiliser plusieurs magnétomètres ayant des orientations différentes ou un magnétomètre multi-axe pour extraire des informations supplémentaires d'une manière similaire à celle avec laquelle on exploite des mesures multi-axe dans d'autres applications. Par exemple, le recours à plusieurs capteurs dans des directions différentes permet de mettre en oeuvre une méthode de séparation des sources dite, d'analyse en composantes indépendantes. On pourra se référer par exemple, à l'article "Blind séparation of sources, Part I : An adaptative algorithm based on neuromimetic architecture" de C. Jutten et J Herault, paru dans Signal Processing 24 (1991) 1-10 - Elsevier.

En outre, la mise en oeuvre pratique de l'invention est à la portée de l'homme du métier à partir des indications fonctionnelles données ci-dessus et des outils usuels de traitement du signal. En particulier, les techniques de corrélofiltrage données à titre d'exemple pourront être remplacées par d'autres techniques de traitement du signal similaires pourvu de respecter les fonctionnalités décrites. De plus, le traitement des signaux pourra être analogique et/ou numérique.

## Revendications

1. Système de mesure d'un mouvement cyclique d'une pièce ferromagnétique (21, 23, 25) dans un environnement bruité au moins par une source électrique (6) à composante alternative, comportant :
au moins un premier magnétomètre (42, 48) sensible à la pièce en mouvement ;
un capteur d'une image (a) du courant dans ladite source électrique ;
des moyens de calcul (8, 8') configurés pour calculer, par filtrage de ladite image du courant, une estimation du bruit (eb6, eb'6) lié à la source électrique sur un signal (m, m') mesuré par le premier magnétomètre ; et
des moyens (46, 46') configurés pour soustraire ladite estimation au signal mesuré.

2. Système selon la revendication 1, dans lequel ladite image du courant dans ladite source alternative (6) est la tension aux bornes de celle-ci.

3. Système selon la revendication 1 ou 2, dans lequel lesdits moyens de calcul (8, 8') comportent au moins un filtre de Wiener.

4. Système selon l'une quelconque des revendications 1 à 3 dans lequel ledit magnétomètre (42) est placé plus près de ladite pièce (21, 23) que de toute autre pièce ferromagnétique (23) en mouvement.

5. Système selon l'une quelconque des revendications 1 à 4, comportant :
au moins un deuxième magnétomètre (48) placé à proximité d'une deuxième pièce ferromagnétique (25) en mouvement ;
des moyens (f48) configurés pour calculer une estimation du bruit (eb48) lié à cette deuxième pièce sur le signal (m) mesuré par le premier magnétomètre (42) ; et
des moyens (46") configurés pour soustraire cette estimation au signal mesuré.

6. Système selon l'une quelconque des revendications 1 à 5, dans lequel ladite source à composante alternative est un alternateur (6) associé à un moteur (2) de véhicule (1).

7. Système selon l'une quelconque des revendications 1 à 5, dans lequel ladite source à composante alternative est le courant alternatif d'un moteur électrique.

8. Procédé d'évaluation d'un mouvement cyclique d'au moins une pièce ferromagnétique (21, 23, 25) dans un environnement bruité au moins par une source électrique (6) à composante alternative, comportant les étapes de :
mesurer une image du champ magnétique (m) influencé au moins par ladite pièce ;
mesurer une image (a) du courant dans ladite source électrique ;
appliquer un corrélofiltrage à ladite image du champ magnétique, en prenant en compte ladite image du courant dans ladite source électrique, pour soustraire une estimation du bruit lié à la source électrique du signal mesuré.

9. Procédé selon la revendication 8, dans lequel une composante de bruit provenant d'une autre pièce ferromagnétique (25) est éliminée par corrélofiltrage en utilisant au moins un deuxième magnétomètre (48) associé à cette deuxième pièce.

## Claims

1. A system for measuring a cyclic motion of a ferromagnetic part (21, 23, 25) in an environment made noisy by at least one electric source (6) with an A.C. component, comprising:
at least one first magnetometer (42, 48) sensitive to the moving part;
a sensor of an image (a) of the current in said electric source;
calculation means (8, 8') arranged for calculating, by filtering said image of the current, an estimate of the noise (eb6, eb'6) due to the electric source on a signal (m, m') measured by the first magnetometer; and
means (46, 46') arranged for subtracting said estimate from the measured signal.

2. The system of claim 1, wherein said image of the current in said A.C. source (6) is the voltage thereacross.

3. The system of claim 1 or 2, wherein said calculation means (8, 8') comprise at least one Wiener filter.

4. The system of any of claims 1 to 3, wherein said magnetometer (42) is placed closer to said ferromagnetic part (21, 23) than to any other moving ferromagnetic part (23).

5. The system of any of claims 1 to 4, comprising:
at least one second magnetometer (48) placed close to a second moving ferromagnetic part (25);
means (f48) arranged for calculating an estimate of the noise (eb48) due to this second part on the signal (m) measured by the first magnetometer (42); and
means (46") arranged for subtracting this estimate from the measured signal.

6. The system of any of claims 1 to 5, wherein said source with an A.C. component is an alternator (6) associated with a motor (2) of a vehicle (1).

7. The system of any of claims 1 to 5, wherein said source with an A.C. component is the A.C. current of an electric motor.

8. A method for estimating a cyclic motion of at least one ferromagnetic part (21, 23, 25) in an environment made noisy by at least one electric source (6) with an A.C. component, comprising the steps of:
measuring an image of the magnetic field (m) influenced at least by said part;
measuring an image (a) of the current in said electric source;
applying a correlation filtering to said image of the magnetic field, by taking into account said image of the current in said electric source, to substract an estimate of the noise linked to the electric source of the measured signal.

9. The method of claim 8, wherein a noise component originating from another ferromagnetic part (25) is eliminated by correlation filtering by using at least one second magnetometer (48) associated with this second part.

## Patentansprüche

1. Ein System zum Messen einer zyklischen Bewegung eines ferromagnetischen Teils (21, 23, 25) in einer Umgebung, die Rauschen unterliegt, welches von wenigstens einer elektrischen Quelle (6) mit einer AC Komponente erzeugt wird, wobei das System Folgendes aufweist:
wenigstens ein erstes Magnetometer (42, 48), ansprechend auf das bewegliche Teil ist;
einen Sensor für ein Bild (a) des Stroms in der elektrischen Quelle;
Berechnungsmittel (8, 8'), die angeordnet sind zum Berechnen einer Schätzung des durch die elektrische Quelle auf einem Signal (m, m') erzeugten Rauschens (eb6, eb'6), das durch das erste Magnetometer gemessen wird, durch Filtern des Bildes des Stroms; und
Mittel (46, 46'), die angeordnet sind zum Subtrahieren der Schätzung von dem gemessenen Signal.

2. Das System nach Anspruch 1, wobei das Bild des Stroms in der AC Quelle (6) der Spannung darüber entspricht.

3. Das System nach Anspruch 1 oder 2, wobei die Berechnungsmittel (8, 8') wenigstens einen Wiener-Filter aufweisen.

4. Das System nach einem der Ansprüche 1 bis 3, wobei das Magnetometer (42) näher an dem ferromagnetischen Teil (21, 23) platziert ist als zu irgendeinem anderen ferromagnetischen Teil (23).

5. Das System nach einem der Ansprüche 1 bis 4, wobei das System ferner Folgendes aufweist:
wenigstens ein zweites Magnetometer (48), das nahe einem zweiten sich bewegenden ferromagnetischen Teil (25) angeordnet ist;
Mittel (f48), die zum Berechnen einer Schätzung des Rauschens (eb48), aufgrund des zweiten Teils auf dem Signal (m), angeordnet sind, das von dem ersten Magnetometer (42) gemessen wird; und
Mittel (46"), die zum Subtrahieren der Schätzung von dem gemessenen Signal angeordnet sind.

6. Das System nach einem der Ansprüche 1 bis 5, wobei die Quelle mit einer AC Komponente ein Wechselstromerzeuger (6) ist, der mit einem Motor (2) eines Fahrzeugs (1) assoziiert ist.

7. Das System nach einem der Ansprüche 1 bis 5, wobei die Quelle mit einer AC Komponente der AC Strom eines Elektromotors ist.

8. Ein Verfahren zum Schätzen einer zyklischen Bewegung von wenigstens einem ferromagnetischen Teil (21, 23, 25) in einer Umgebung, die Rauschen unterliegt, welches von wenigstens einer elektrischen Quelle (6) mit einer AC Komponente erzeugt wird, wobei das Verfahren die folgenden Schritte aufweist:
Messen eines Bildes des magnetischen Feldes (m), das durch wenigstes das Teil beeinflusst wird;
Messen eines Bildes (a) des Stroms in der elektrischen Quelle;
Anlegen einer Korrelationsfilterung an das Bild des magnetischen Feldes durch Berücksichtigen des Bildes des Stromes in der elektrischen Quelle, um eine Schätzung des Rauschens, das mit der elektrischen Quelle verknüpft ist, von dem gemessenen Signal zu subtrahieren.

9. Das Verfahren nach Anspruch 8, wobei eine Rauschkomponente, die von einem weiteren ferromagnetischen Teil (25) herrührt, durch eine Korrelationsfilterung eliminiert wird, durch die Verwendung von wenigstens einem zweiten Magnetometer (48), das mit dem zweiten Teil assoziiert ist.
